# EUROPÄISCHE PATENTANMELDUNG

(11) **EP 0 994 417 A2**
(43) Veröffentlichungstag der Anmeldung: **19.04.2000**
(21) Anmeldenummer: 99117721.3
(22) Anmeldetag: 08.09.1999
(51) Int. Cl.: G06F 11/22

(54) **Schaltungsanordnung und Verfahren zur Überprüfung von Daten**

(30) Priorität: 09.09.1998 DE 19841201
(71) Anmelder: SIEMENS AKTIENGESELLSCHAFT, 80333 München (DE)
(72) Erfinder: Musil, Gerhard, 81479 München (DE)

(57) **Zusammenfassung**

Bei dieser Schaltungsanordnung und dem dazugehörigen Verfahren werden die in einem ersten Speicher eines Prozessors gespeicherten Konfigurationsdaten zur Inbetriebnahme einer Geräteeinheit erst freigegeben, wenn eine die Konfigurationsdaten kennzeichnende Kennung mit einer Kennung übereinstimmt, die in einer elektrisch mit der Rückwand der Geräteeinheit untrennbar verbundenen zweiten Speichereinheit übereinstimmt. Die zweite Speichereinheit wird vorzugsweise aus passiven Elementen gebildet.

## Beschreibung

Zur Speicherung von dauerhaft zu speichernden Daten die nachfolgend auch als Konfigurationsdaten bezeichnet werden, wurden bisher Speichereinheiten auf der Prozessoreinheit oder auf Rückwandleiterplatten bevorzugt Festwertspeicher wie programmierbarer NUR-Lese-Speicher EEPROM oder FPROM verwendet. Diese Art der Speicherung von Konfigurationsdaten bringt jedoch den Nachteil mit sich, daß diese bei einem notwendig werdenden Ersatz des genannten Festwertspeichers aus mechanisch bedingten Gründen nur sehr schwer ausgetauscht werden können. Bei einem Wechsel des Festwertspeichers können dann durch eine fehlerhafte Programmierung oder durch Verwechslungen bei einem Austausch des Festwertspeichers die Konfigurationsdaten verändert werden.

Der Erfindung liegt die Aufgabe zugrunde, eine Schaltungsanordnung und ein Verfahren zur Überprüfung von Daten anzugeben, bei der die oben aufgeführten Nachteile vermieden werden.

Gemäß der Erfindung wird die gestellte Aufgabe durch die Patentansprüche 1 und 7 gelöst.

Die Erfindung bringt den Vorteil mit sich, daß die zweite Speichereinheit störunanfällig ist und nicht ausgetauscht zu werden braucht.

Die Erfindung bringt den Vorteil mit sich, daß eine Verwechslung von Daten durch falsche Programmierung oder Bestückung der zweiten Speichereinheit ausgeschlossen ist.

Die Erfindung bringt den Vorteil mit sich, daß Konfigurationsdaten innerhalb gleichartiger Einschubbaugruppen oder Geräteeinheiten redundant abgespeichert werden können, wobei gültige Datensätze von evtl. nicht zum Gerät gehörende Daten sicher unterschieden werden können.

Die Erfindung bringt den Vorteil mit sich, daß der zweite Speicher untrennbar mit der Rückwandleiterplatte verbunden ist.

Weitere vorteilhafte Ausbildungen der Schaltungsanordnung und des Verfahrens sind in den weiteren Patentansprüchen angegeben.

Weitere Besonderheiten der Erfindung werden aus den nachfolgenden näheren Erläuterungen eines Ausführungsbeispieles anhand von Zeichnungen ersichtlich.

Es zeigen:
Figur 1 eine Gerätekonfiguration,
Figur 2 eine Zuordnung von Speicherinhalten,
Figur 3 Verbindungen zu weiteren Einheiten und
Figur 4 eine Realisierung einer zweiten Speichereinheit.

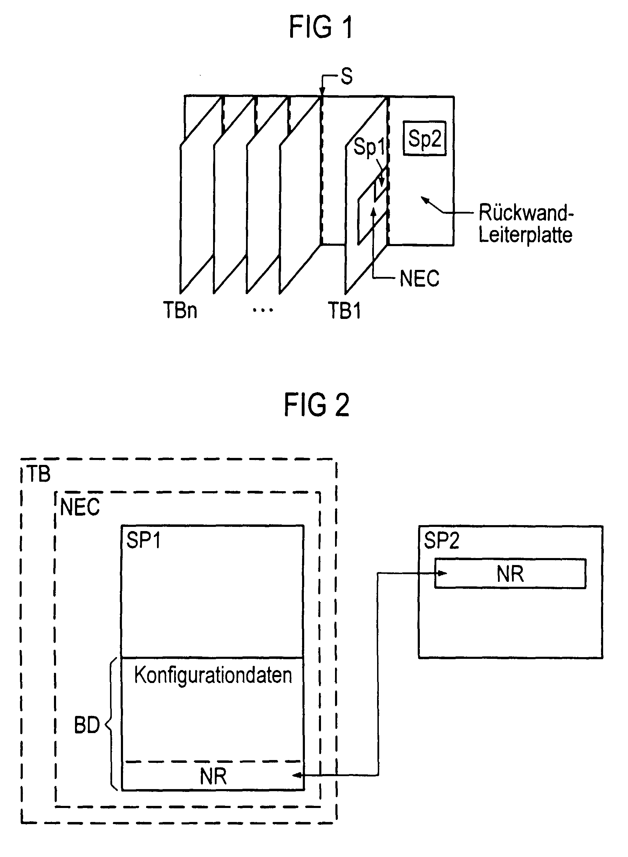

In Figur 1 ist eine Konfiguration einer Geräteeinheit bzw. eines Baugruppenträgers dargestellt, die aus einer Rückwandleiterplatte RP und Einschubbaugruppen TB1,.. , TBn bestehen können. Auf einer Einschubbaugruppe TB1 ist ein Prozessor NEC angeordnet der nachfolgend als Netzelement-Controller bezeichnet wird. Die Einschubbaugruppen TB1,.. , TBn sind über Verbindungsleitungen S beispielsweise Steckverbinder mit der Rückwandleiterplatte RP verbunden. In dem Netzelement-Controller NEC ist eine erste Speichereinheit SP1 und auf der Rückwandleiterplatte RP ist eine zweite Speichereinheit SP2 angeordnet.

Bei dieser Gerätekonfiguration sind austauschbare Einschubbaugruppen TB1,..., Tbn über Steckerleisten mit der Rückwandleiterplatte RP verbunden. Dabei sind die Einschubbaugruppen TB1,.. ,TBn für systemrelevante Funktionen und die Einschubbaugruppe TB1 mit dem Netzelement-Controller NEC auch für Überwachungs- und Steuerfunktionen zuständig. Zu diesen Überwachungs- und Steuerfunktionen werden Basisdaten die auch als Konfigurationsdaten bezeichnet werden können benötigt, die unverwechselbar jedem einzelnen Gerät zugeordnet sind. Die Basisdaten können eine Adresse des Gesamtgerätes, veränderliche Daten, Grundinformationen die das Gerät braucht, um seine Identität zu erkennen oder Angaben zu einer Minimalkonfiguration und Einstellungen enthalten, die nicht allgemein definierbar sind, da sie z.B. vom Einsatzort abhängig sind, sein.

Die meisten der Einschubbaugruppen TBn und die Einschubbaugruppe TB1 mit dem Netzelement-Controller NEC haben eine Mikroprozessoreinheit mit einem Permanentspeicher. Wenn keine der Einschubbaugruppen TBn eine Mikroprozessoreinheit aufweist, so hat zumindest eine der Einschubbaugruppen einen Permanentspeicher, der vom Netzelement-Controller NEC gelesen und/oder beschrieben werden kann.

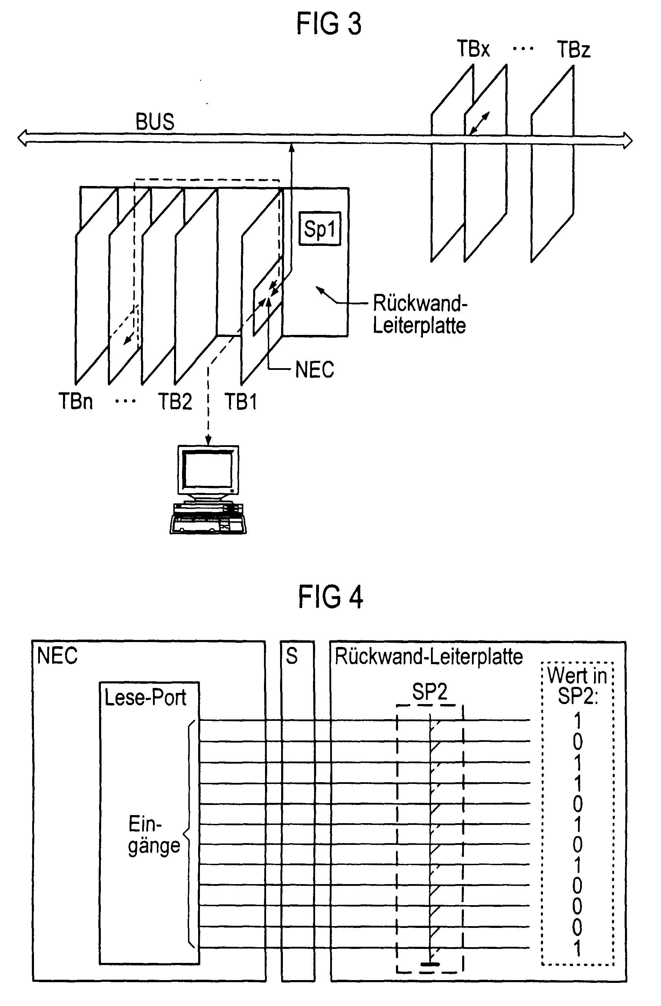

Die auf der Rückwandleiterplatte RP angeordnete zweite Speichereinheit SP2 besteht, wie in Figur 4 gezeigt, aus Leitungen, Lötbrücken oder Durchführungen auf die Rückwandleiterplatte RP. Die zweite Speichereinheit SP2 kann auch aus einer Diodenmatrix oder ähnlichen Elementen die eine hohen Zuverlässigkeit aufweisen gebildet sein.

Die zweite Speichereinheit SP2 kann vom Netzelement-Controller NEC ausgelesen werden. In der zweiten Speichereinheit SP2 ist eine Kennung hinterlegt mit der die Konfigurationsdaten der Geräteinheit verwechslungsfrei erkennbar sind. Die zu einem Gerät gehörigen Konfigurationsdaten werden dabei als solche erkannt, wenn die Kennung die zu den Konfigurationsdaten in der ersten Speichereinheit SP1 des Netzelemente-Controllers NEC mit der in der zweiten Speichereinheit SP2 auf der Rückwandleiterplatte gespeicherten übereinstimmt.

Nachfolgend ist ein Speichervorgang für die Konfigurationsdaten beschrieben:

Bei einer Erstinstallation der Geräteeinheit wird die Einschubbaugruppe TB1 mit dem Netzelement-Controller NEC z.B. über einen Bedienrechner konfiguriert oder bereits vorkonfiguriert angeliefert. Die Daten zur Konfiguration speichert der Netzelement-Controller NEC in seinem eigenen ersten Speicher SP1 mit dem Inhalt der zweiten Speichereinheit SP2. Diese in der ersten Speichereinheit SP1 abgelegten Daten ergeben einen Datensatz BD (siehe Fig. 2). Nach Bildung dieses Datensatzes BD wird dieser auf der Einschubbaugruppe TB1 permanent gespeichert und/oder auch zu möglichst vielen Einschubbaugruppen TBn,.., TBm übertragen.

Wird die Spannungsversorgung einer Geräteeinheit abgeschaltet oder der Netzelement-Controller NEC, eventuell mit einigen Einschubbaugruppen TBn, in einen Baugruppenträger gesteckt, so geschieht folgendes:
Der Netzelement-Controller NEC liest beim Hochlauf den Inhalt der zweiten Speichereinheit SP2 auf der Rückwandleiterplatte. Stimmt der Inhalt der zweiten Speichereinheit SP2 mit dem überein, was er selbst als Kennung im Datensatzes BD gespeichert hat, so erkennt der Netzelement-Controller NEC, daß er sich im bestimmungsgemäßen Baugruppenträger befindet.

Stimmt der Inhalt der zweiten Speichereinheit SP2 nicht mit der im Datensatz BD angegebenen Kennung überein, so fragt der Netzelement-Controller NEC die Permanentspeicher der anderen Einschubbaugruppen TB2, .., TBn des Baugruppenträgers des Netzelement-Controllers NEC ab. Findet der Netzelement-Controller NEC einen Datensatz BD dessen Kennung mit der im zweiten Speicher SP2 übereinstimmt, so erkennt der Netzelement-Controller NEC, daß ein gültiger Datensatz BD vorliegt und übernimmt den Datensatz aus dem Permanentspeicher der betreffenden Einschubbaugruppe TBn. Es genügt also, daß eine einzige Einschubbaugruppe TBn mit einem Speicherelement nicht getauscht wurde, um gültige Konfigurationsdaten zu erhalten. Bei diesem Verfahren sind keinerlei Mehrheitsentscheide oder andere kompliziertere Verifikationsverfahren nötig.

Gibt es Einschubbaugruppen, die nicht zum Netzelement-Controller NEC passende Daten enthalten, so kann der Netzelement-Controller NEC im weiteren Verlauf auch den Datensatz der Einschubbaugruppe aktualisieren.

In dem Fall, daß keine einzige Einschubbaugruppe die in der zweiten Speichereinheit SP2 passende Kennung hat, kann der Netzelement-Controller NEC mit Sicherheit erkennen, daß er nicht die richtigen Daten hat und auch nicht selbsttätig bekommen kann. Je nach Anwendungsfall wird dann der Netzelement-Controller NEC dies signalisieren und so gültige Daten von einem Bedienrechner anfordern, den Betrieb abbrechen oder mit allgemeingültigen Ersatzdaten weiterarbeiten.

Werden im Laufe des Betriebs von einem Bedienrechner die Konfigurationsdaten geändert, so werden sie anschließend vom Netzelement-Controller NEC nicht nur als Datensatz BD auf der Einschubbaugruppe TB1 des Netzelement-Controllers NEC gespeichert, sondern wie bei der Erstinstallation beschrieben, auch auf möglichst viele andere Einschubbaugruppen verteilt.

Durch diese Vorgehensweise steht bei einem späteren Austausch der Einschubbaugruppe TB1 mit dem Netzelement-Controller NEC immer die aktuelle Version der Basisdaten BD dem Netzelement-Controller NEC zur Verfügung.

In Figur 2 ist die Anordnung der ersten und zweiten Speichereinheit SP1, SP2 in denen die Kennung mit Konfigurationsdaten und nur die Kennung gespeichert ist dargestellt. Die Konfigurationsdaten sind wie bereits oben beschrieben in einem Speicherbereich des Netzelemente-Controllers NEC abgespeichert. Die Konfigurationsdaten bilden mit der Kennung den Basisdatensatz BD. Zusätzlich ist die Kennung, z.B. eine Zahlenfolge, in der zweiten Speichereinheit SP2 hinterlegt. Diese zweite Speichereinheit SP2 ist vorzugsweise aus passiven Elementen gebildet. Eine Ausbildung der zweiten Speichereinheit SP2 ist in Figur 4 gezeigt.

In Figur 3 ist eine Schaltungsanordnung gezeigt wie bei einem Nichtvorhandensein der richtigen Kennung der Netzelement-Controller NEC diese in einem Permanentspeicher der Einschubbaugruppen TBn der Geräteeinheit oder über einen Bus in identischen Geräteeinheiten sucht um an die Konfigurationsdaten zu gelangen. Ist eine Suche nach der Kennung in anderen Einheiten erfolglos, so können wie oben beschrieben Konfigurationsdaten beispielsweise über einen Bedienrechner eingegeben werden.

In Figur 4 ist eine Realisierung der zweiten Speichereinheit SP2 dargestellt. In dieser Ausführung ist ein 12-Bit-Speicher dargestellt. Mit einem 12-Bit-Speicher können 4096 unterschiedliche Kennungen für Basisdatensätze vergeben werden. Die Codierung der Speichereinheit SP1 kann entweder durch Auftrennen der Leitungen oder durch Durchkontaktierungen der Rückwandleiterplatte erfolgen.

Sind eine größere Anzahl von Geräten zu kennzeichnen, so kann beispielsweise ein 24-Bit-Speicher verwendet werden. Mit diesem 24-Bit-Speicher können dann 16,7 Mio Geräte bzw. Einschubbaugruppen näher bestimmt werden. Eine Ausführungsform kann dann eine Diodenmatrix, wie sie in Tastaturen verwendet wird, die wirtschaftlichste Lösung sein. Für diese Ausführungsvariante genügen 3+8 Leitungen zum Auslesen der Daten. Die Codierung würde hier ebenfalls z.B. durch Auftrennen von Leitungen zu diesen Dioden erfolgen oder bei der Fertigung die Rückwände in der Weise durchnummerieren, daß jeweils die einer Eins entsprechende Position mit einer Diode bestückt würde, die Null aber unbestückt bliebe.

In dem dargestellten Beispiel besteht die zweite Speichereinheit SP2 aus 12 individuell aufzutrennenden Leitungen. Diese zweite Speichereinheit SP2 kann über dafür vorgesehene Eingänge des Netzelement-Controllers NEC ausgelesen werden. Das Bezugspotential ist die Masseleitung, deren Verbindung zum Netzelement-Controller NEC hier nicht gezeichnet ist.

Bei der gezeigten Ausführungsvariante ist es Vorteilhaft, wenn die zweite Speichereinheit SP2 auf der Rückwand der Rückwandleiterplatte möglichst nahe der Steckerleiste S der Einschubbaugruppe TB1 wegen der kurzen Verbindungswege liegt. Angeschlossen wird der Netzelement-Controller NEC an diese über insgesamt 12 bei dem einfachsten 12-Bit-Speicher bzw. über 11 Leitungen bei einem 24-Bit-Speicher einer Diodenmatrix. Die Anschlüsse werden über einen Baugruppenstecker S geführt. Bei der Ausführungvariante mit der Diodenmatrix könnten acht Anschlüsse des Mikroprozessor-Busses selbst verwendet werden. Da alle Anschlüsse nur dem Lesen dienen, können sie über Widerstände gepuffert werden, was vorteilhaft ist zur Vermeidung von Störungen.

Als Beispiel ist der Binär-Wert 101101010001 = 2897 dargestellt, wobei jede der durchgetrennten schrägen Leitungen zum Bezugspotential eine Eins repräsentiert und der im Bild oberste Eingangspin das höchstwertige Bit darstellt. Die voll gezeichneten schrägen Leitungen repräsentieren die nicht durchtrennten Leitungen, die jeweils eine Null entsprechen.

Beim Lesen der zweiten Speichereinheit SP2 werden z.B. über nicht gezeichnete Widerstände auf dem Netzelement-Controller NEC die Leitungen zum Lese-Fort des Controller auf das Potential, das dem Potential Null entgegengesetzt ist, gelegt. Dort, wo die Speicherleitung nicht durchtrennt ist, wird das festgehaltene Potential jetzt als eine Null gelesen, sonst als eine Eins. Der Wert kann bitweise direkt oder indirekt eingelesen werden, wenn das die Busbreite des Controllers erlaubt.

Beschrieben wird diese Art der zweiten Speichereinheit SP2 nicht vom Netzelement-Controller NEC aus, sondern durch gezielte Eingriffe während der Fertigung der Rückwandleiterplatte. Eine Codierung kann auch durch Auftrennen oder Durchschmelzen der Leitungen in der zweiten Speichereinheit SP2 erreicht werden. Ein Durchschmelzen ist z.B. mit einem einfachen Programmiergerät möglich, das an die Steckerleiste für den Netzelement-Controller NEC angeschlossen werden kann. Ein einfacher Schalter zur Eingabe der Zahl und eine Batterie mit ca. 1 Volt werden hierfür genügen.

Wenn vom Kunden erwünscht, kann die zweite Speichereinheit SP2 in bekannter Weise auch mit gebräuchlichen Dual-In-Line-Codierschaltern, Lötbrücken und dgl. realisiert werden. Diese kann auch am Gestell für die Geräteeinheit befestigt sein und mit deren Rückwand elektrisch untrennbar verbunden werden. Wesentlich ist dabei, daß die zweite Speichereinheit SP2 bei den Wartungsvorgängen wie z.B. Geräteeinstellungen über Rechner, Baugruppentausch usw. immer im Gerät verbleibt.

## Patentansprüche

1. Schaltungsanordnung zur Überprüfung von Daten einer Geräteeinheit mit mindestens einer einen Prozessor (NEC) aufweisenden Baugruppe (TB1), die über Verbindungen (S) mit einer Rückwandleiterplatte (RP) verbunden ist,
**dadurch gekennzeichnet**,
daß ein Speicherbereich zur Abspeicherung einer zu den Daten gehörenden Kennung in einer dem Prozessor zugeordneten ersten Speichereinheit (SP1) vorgesehen ist,
daß eine zweite Speichereinheit (SP2) zur Speicherung der Kennung auf der Rückwandleiterplatte (RP) angeordnet ist, wobei die Kennung von dem Prozessor (NEC) aus der zweiten Speichereinheit (SP2) gelesen und diese mit der gespeicherten Kennung in der ersten Speichereinheit (SP1) verglichen wird und bei Übereinstimmung die Daten freigegeben werden.

2. Schaltungsanordnung nach Anspruch 1,
**dadurch gekennzeichnet**,
daß die Geräteeinheit mindestens eine weitere Einschubbaugruppe (TB1,..., TBn) mit mindestens einem Permanentspeicher aufweist, wobei der Prozessor (NEC) bei Nichtübereinstimmung der in der ersten Speichereinheit (SP1) hinterlegten Kennung mindestens die in einem Permanentspeicher hinterlegte Kennung überprüft und bei Übereinstimmung ohne eine Mehrheitsentscheidung die zu der Kennung gehörenden Daten einliest.

3. Schaltungsanordnung nach Anspruch 1,
**dadurch gekennzeichnet**,
daß die zweite Speichereinheit (SP2) aus passiven Speicherelementen gebildet ist.

4. Schaltungsanordnung nach Anspruch 1,
**dadurch gekennzeichnet**,
daß die zweite Speichereinheit (SP2) aus einer Matrix aus einer Mehrzahl von Zeilen (n) und einer Spalte gebildet ist, wobei bei einer Verbindung zwischen einer Zeile und einer Spalte eine Null, ansonsten eine Eins in der Spalte vermerkt ist.

5. Schaltungsanordnung nach Anspruch 1,
**dadurch gekennzeichnet**,
daß die zweite Speichereinheit (SP2) aus einer Matrix aus einer Mehrzahl von Zeilen und Spalten gebildet ist.

6. Schaltungsanordnung nach den Ansprüchen 1,3,4 oder 5,
**dadurch gekennzeichnet**,
daß der Prozessor (NEC) der Zeilenzahl (n) der zweiten Speichereinheit (SP2) entsprechende Leseeingänge aufweist.

7. Verfahren zur Überprüfung von Daten einer Geräteeinheit mit mindestens einer einen Prozessor (NEC) aufweisenden Baugruppe (TB1), die über Steckverbindungen (S) mit einer Rückwandleiterplatte (RP) verbunden werden,
**dadurch gekennzeichnet**,
daß eine zu den Daten gehörende Kennung in einer dem Prozessor (NEC) zugeordneten ersten Speichereinheit (SP1) abgespeichert wird,
daß die Kennung in einer zweite Speichereinheit (SP2) auf der Rückwandleiterplatte (RP) abgespeichert wird, wobei die Kennung von dem Prozessor (NEC) aus der zweiten Speichereinheit (SP2) gelesen und diese mit der in der ersten Speichereinheit (SP1) gespeicherten Kennung verglichen wird und bei Übereinstimmung die Daten freigegeben werden.

8. Verfahren nach Anspruch 7,
**dadurch gekennzeichnet**,
daß die Geräteeinheit mindestens eine weitere Einschubbaugruppe (TB1,..., TBn) mit mindestens einem Permanentspeicher aufweist, wobei der Prozessor (NEC) bei Nichtübereinstimmung der in der ersten Speichereinheit (SP1) hinterlegten Kennung eine in mindestens einem Permanentspeicher gespeicherten Kennung überprüft und bei Übereinstimmung die zu der Kennung gehörenden Daten ohne einen Mehrheitentscheid einliest.
